# EUROPEAN PATENT APPLICATION

(11) **EP 1 583 160 A2**
(43) Date of publication of application: **05.10.2005**
(21) Application number: 05075731.9
(22) Date of filing: 29.03.2005
(51) Int. Cl.: H01L 33/00

(54) **Microelectronic assembly with underchip optical window, and method for forming same**

(30) Priority: 01.04.2004 US 815529
(71) Applicant: Delphi Technologies, Inc., Troy, MI 48007 (US)
(72) Inventor: Brandenburg, Scott D., Kokomo, IN 46902 (US); Tsai, Jeehuei S., Carmel, IN 46032 (US); Burns, Jeffrey H., Kokomo, IN 46902 (US)
(74) Representative: Denton, Michael John

(57) **Abstract**

A microelectronic assembly includes an integrated circuit die spaced apart from a substrate and connected by bump interconnections, and an polymeric encapsulant molded about the die. The encapsulant extends into the gap about the interconnections, but is confined to the perimeter so as to define an underchip optical window adjacent the central region of the die. The window allows optical access to the active face of the die, including to optical sensors thereon. During manufacture of the assembly, following attachment of the die on the substrate, a molding cavity is positioned about the die on the substrate. Polymeric material is injected into the cavity at a pressure effective to initiate flow into the gap about the solder bump interconnections. The pressure is then reduced to prevent flow of the polymeric material into the central region.

## Description

### TECHNICAL FIELD

This invention relates to a microelectronic assembly that includes an integrated circuit die attached to a substrate by solder bump interconnections. More particularly, this invention relates to such assembly that includes an overmolded polymeric encapsulant that extends within a gap between the integrated circuit die and the substrate to protect the solder bump interconnections and further that defines an optical window to allow the integrated circuit device to receive and emit optical signals through the substrate.

### BACKGROUND OF INVENTION

A typical flip chip microelectronic assembly comprises an integrated circuit die, also commonly referred to as a chip, mounted on a substrate, such as a printed circuit board, by solder bump interconnections that physically attach the chip to the substrate and also form electrical connections for conducting electrical signals to and from the chip for processing. To form the assembly, solder bumps are affixed to bond pads disposed on the active face of the chip. The chip is arranged on the substrate, and the arrangement is heated and cooled to reflow the solder and thereby form the interconnections. In the assembly, the chip is spaced apart from the substrate by a gap. The space about the solder bump interconnections within the gap is typically filled with a polymeric encapsulant. The encapsulant protects the solder bump interconnections from corrosion; and also reinforces the interconnections to withstand vibration and other mechanical forces to which the assembly is subjected during use.

Also, because of thermal cycling experienced by the assembly during operation, it is an important role of the encapsulant to reduce stresses in the interconnections due to differences in expansion and contraction of the die relative to the substrate during operation. This thermally induced stress, if not for the encapsulant, would cause fatigue in the solder and lead to fracture of the interconnections and failure of the assembly. The difference in expansion and contraction are indicated by a mismatch in the coefficients of thermal expansion, referred to as CTE. In general, it is desired to use an encapsulant having a CTE similar to the adjacent materials. For example, for a printed circuit board formed of a common polymer glass laminate, it is desired to adjust the encapsulant CTE to between about 12 and 17 parts per million (ppm) per degree Centigrade (°C), whereas a CTE between about 6 and 10 ppm per °C is preferred for glass substrates. The encapsulant is composed of a polymeric matrix and contains an addition, typically between about 75% and 90% per cent by weight, of particulate silica or other inorganic filler to reduce the CTE to within the desired range. The high filler content produces an encapsulant that is opaque.

It is known to fabricate an integrated circuit die that includes an optical element. For example, a digital camera comprises a die having an array of light sensors that receive and process light to produce an image. Other known dies include optical emitter or detector for sending or receiving optical signals for processing. The optical element is formed as on the active face of the die and receives or emits signals generally perpendicular to the face. When incorporated in a flip chip assembly, in which the active face faces the substrate, the optical signal is received through or emitted toward the substrate. Opaque encapsulant within the gap blocks the optical signal and thus interferes with useful operation of the assembly.

Therefore, a need exists for a microelectronic assembly in which the integrated circuit chip, is mounted onto a substrate by solder bump interconnections, and wherein the solder bump interconnections are protected by a polymeric encapsulant disposed within the gap between the chip and the substrate, and further wherein the encapsulant defines an optical window for transmitting optical signals to or from the chip through the substrate.

### SUMMARY OF THE INVENTION

In accordance with this invention, a microelectronic assembly comprises an integrated circuit die mounted on a substrate by a plurality of bump interconnections. The die includes an active face having a central region surrounded by a perimeter region, and is arranged relative to the substrate such that the active face faces the substrate and is spaced apart by a gap. The bump interconnections are bonded to the perimeter region of the die and to the substrate, to thereby attach the die to the substrate. The assembly also includes a polymeric encapsulant about the die on the substrate and extending into the gap to encapsulate the interconnections. The encapsulant defines an optical window within the gap underlying the central region. It is an advantage of this invention that the window allows optical access to the active face of the die, including the optical sensors thereon. Moreover, the assembly may be formed using an encapsulant having a desired CTE that is adjusted for protecting the bump interconnections from thermally induced stress.

In one aspect of this invention a method is provided for forming a microelectronic assembly having an overmolded polymeric encapsulant that defines an underchip optical window. The method comprises attaching an integrated circuit device to a substrate by a plurality of bump interconnections, such that the active face of the die faces the substrate spaced apart by a gap. The bump interconnections are bonded to the die at a perimeter region surrounding a central region. The method further comprises molding or otherwise disposing a polymeric encapsulant about said integrated circuit device on said substrate such that the polymeric encapsulant extends within the gap to encapsulate the bump interconnections, but not within the central region. In a preferred embodiment, this is accomplished by forming a molding cavity about the die on the substrate, injecting a polymeric material into the cavity at a first pressure effective to initiate flow into the gap about the bump interconnections, reducing the applied pressure to prevent flow of the polymeric material into the gap adjacent the central region, and thereafter curing the polymeric material to form the encapsulant. In this manner, injection of the polymeric material is controlled to assure protection of the bump interconnections without blocking optical access to the central region of the die.

### BRIEF DESCRIPTION OF DRAWINGS

This invention will be further described with reference to the accompanying drawings in which:
Fig. 1 is a cross sectional view of a microelectronic assembly in accordance with this invention;
Fig. 2 is a cross sectional view of the microelectronic assembly in Fig. 1 taken along lines 2-2 in the direction of the arrows;
Fig. 3 is a molding arrangement during the manufacture of the microelectronic assembly in Fig. 1; and
Fig. 4 is a graph showing injection molding pressure and cavity fill as a function of time during the manufacture of the microelectronic assembly in Fig. 1.

### DETAILED DESCRIPTION OF INVENTION

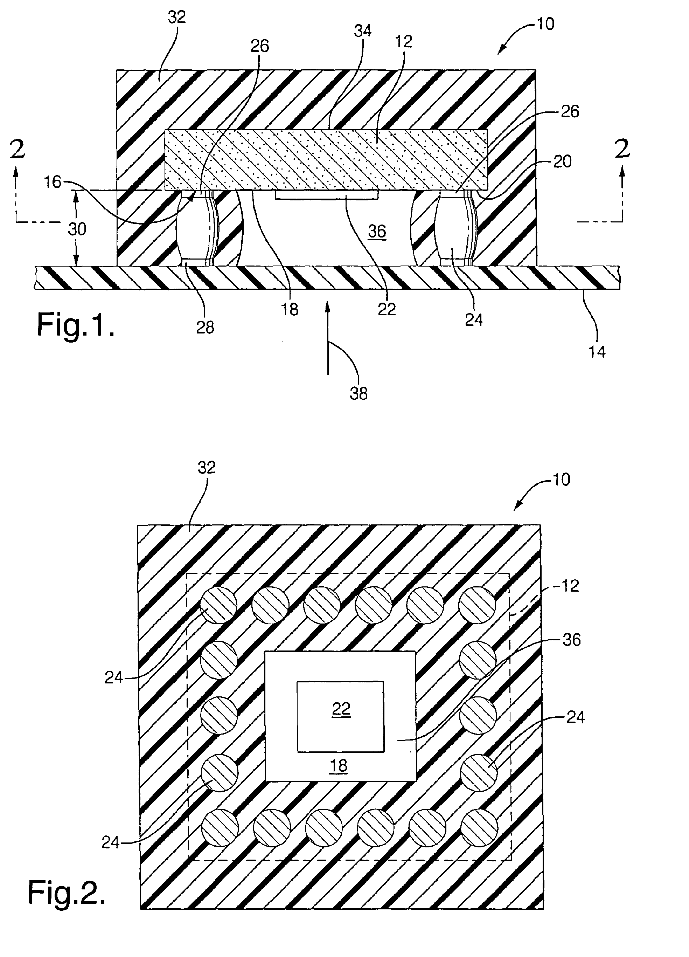

In accordance with a preferred embodiment of this invention, referring to Figs. 1 and 2, a microelectronic assembly 10 comprises an integrated circuit die 12 mounted onto a substrate 14 in a flip chip arrangement. Substrate 14 is formed of a transparent material. A preferred material is glass. Alternately, the substrate may be formed of a polymeric thin film or a polymer glass laminate, such as an FR4 board. Die 12 is formed of a semiconductor material, preferably silicon, and comprises an active face 16 that includes a central region 18 surrounded by a perimeter region 20. An optical feature 22 is formed on the active face at the central region. In a preferred embodiment, die 12 may be an digital imaging device that includes, as feature 22, an array of optical sensors and related circuitry for sensing and processing light to produce an image, such as a digital picture. Alternately, feature 22 may be detector for receiving an optical signal, or an element for emitting an optical signal.

In the preferred embodiment, die 12 is attached to substrate 14 by a plurality of solder bump interconnections 24. For this purpose, die 12 comprises bond pads 26 distributed about the perimeter region in a perimeter array. Substrate 14 includes bond pads 28 in a corresponding arrangement to register with bond pads 26. Connections 24 are formed of near-eutectic tin-lead solder alloy or other suitable solder alloy and bond to pads 26 and 28 to attach die 12 to substrate 14. Connections 24 are also adapted for transmitting electrical signals to and from die 12 for processing. Although solder bump interconnections are used in the preferred embodiment, the assembly may suitably comprise stud bump connections wherein a bump, typically formed of gold, is affixed to the bond pad on the die and attached to the substrate pad by solder or conductive adhesive. As used herein, bump interconnections refers to solder bump interconnections, stud bump interconnections or other suitable interconnections formed within the gap to mechanically and electrically attach the die to the substrate. In the preferred embodiment, it is a significant feature that die 12 is attached such that optical feature 22 faces substrate 14 and is spaced apart by a gap 30.

In accordance with this invention, assembly 10 further comprises an overmolded polymeric encapsulant 32 to protect die 12 on substrate 14. Preferably, encapsulant 32 forms a continuous body that overlies rear face 34 of die 12 opposite active face 16 and bonds to the surface of substrate 14 about the die. Alternately, the encapsulant 32 may be disposed about the die without covering the rear face. Significantly, encapsulant 32 extends within gap 30 to encapsulate interconnections 24. The encapsulant composition suitably comprises particulate inorganic filler, such as silica particles, dispersed in a thermoset polymeric matrix, which is preferably an epoxy polymer. In general, it is desired to formulate the encapsulant to contain particulate silica or other filler in an amount, typically between about 75% and 90%, to adjust the CTE to within a desired range. The desired CTE is dependent upon the nature of the substrate, and is between about 6 and 10 ppm per C for a preferred glass substrate. The high filler content renders the encapsulant opaque. In addition, the encapsulant commonly includes a carbon powder addition, typically less than 1%, that imparts a black color. By way of example, a suitable encapsulant material is commercially available from Cookson Semiconductor Inc. under the trade designation 200.302B. It is a significant feature that the encapsulant encloses the interconnections 24 within gap 30 and preferably exhibits a CTE comparable to the substrate material. During use, die 12 and substrate 14 are subjected to cyclic heating and cooling caused by ambient temperature fluctuations, or as the result of heat generated by the die during operation. Encapsulant 32 surrounds the interconnections to reduce stress that would otherwise result from differences in the expansion or contraction of the die and substrate. In addition, encapsulant 32 also forms a barrier to protect the interconnections from the atmosphere that would otherwise tend to cause corrosion of the solder alloy, and reinforces the interconnections against damage due to vibration or other mechanical forces.

In accordance with this invention, encapsulant 32 within gap 30 is limited to the perimeter region 18 and does not extend within the central region 18. In this manner, encapsulant 32 defines an optical window 36 adjacent optical feature 22 on die 12. During use, light, indicated by arrow 38, propagates through substrate 14 and through optical window 36 and is received by optical feature 22 for detection and processing. In an alternate embodiment wherein feature 22 emits light, the emitted light is transmitted through window 36 and substrate 14. In any event, the absence of encapsulant material allows the light to be transmitted through the optical window without interference.

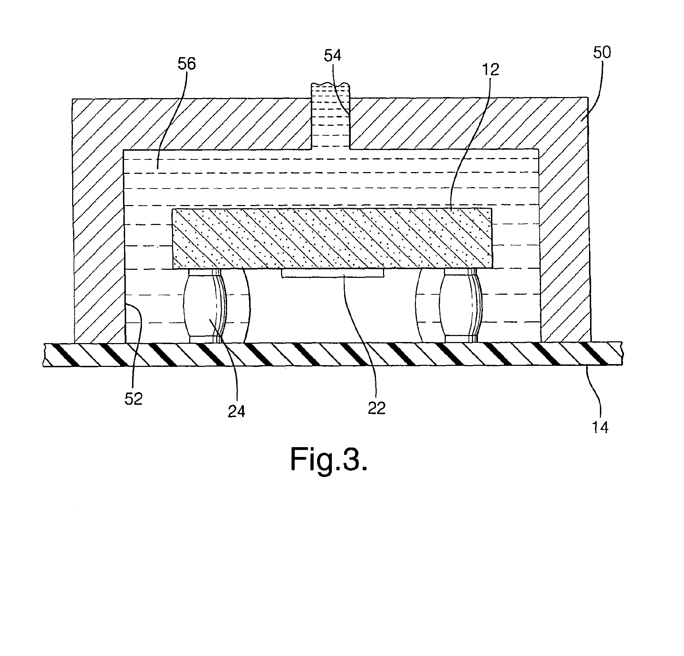

Referring now Fig. 3, microelectronic assembly 10 is manufactured by initially attaching die 12 to substrate 14 by a flip chip process. Suitable flip chip processes are well known. A preferred process comprises distributing a microsphere of a suitable solder alloy onto each bond pad 26 on die 12, and heating and cooling the die to reflow the solder and form a solder bump bonded to the die bond pad. The die with the solder bumps is then arranged on the substrate such that each bump rests in contact with a corresponding bond pad on the substrate. The arrangement is then heated and cooled to bond the solder bump to the bond pad on the substrate, as well as the die, to thereby physically attach the die to the substrate and to concurrently electrically connect the bond pad on the die to the corresponding bond pad on the substrate.

Following attachment, a mold 50 is positioned about the die on the substrate. Mold 50 engages the substrate about the die attach region, so that the mold and substrate cooperate to form a molding cavity 52. A charge of an encapsulant precursor material 56 is injected into cavity 52 through an opening 54 in mold 50. In a preferred embodiment, the material comprises particulate silica filler dispersed in a liquid phase that contains curable epoxy polymer compound. Preferably, cavity 52 is evacuated prior to injecting the polymeric material to facilitate charging and minimize gas bubbles in the product encapsulant. During injection, pressure is applied to the material to increase flow into the cavity. The applied pressure initiates flow of the material into the gap about the interconnections. In accordance with this invention, following initial flow of the material within the cavity, the applied pressure is reduced to a second value that limits flow of the material into the gap. As a result, flow of the material is confined to the perimeter region, and the window is formed adjacent the central region. The material is cured within the mold at about 165 °C, thereby forming the encapsulant, whereafter the mold is removed.

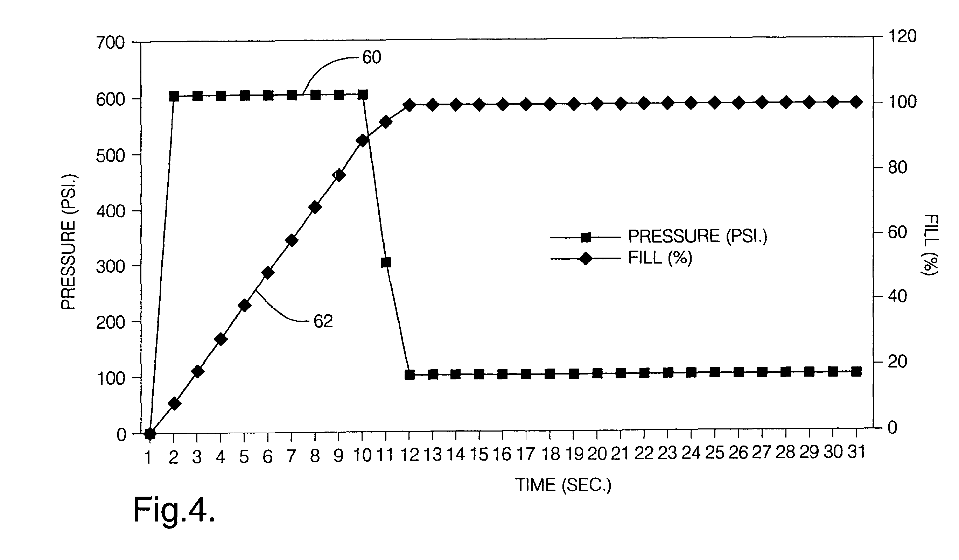

Referring to Fig. 4, there is depicted a preferred molding profile for forming an overmolded encapsulant having an optical window in accordance with this invention. In this example, the encapsulant is formed of an epoxy material containing particulate silica filler. The charge of precursor material is preheated to 85 °C and 125 °C. Referring to curve 60, a pressure of about 600 psi is applied to inject the charge into the cavity. The fill rate of the cavity is shown by line 62. After the volume of injected material corresponds to about 90% of the volume of the cavity, the applied pressure is rapidly reduced to about 100 psi to complete filling of the cavity. Thereafter, the material is heated to about 165 °C to cure the epoxy material and form the product encapsulant. In general, it is desired to apply a high injection molding pressure to minimize processing time and avoid settling of the particulate filler, thereby producing a uniform encapsulant composition. The high applied pressure also produces flow into the underchip gap. Preferably, a pressure of at least about 350 psi to 750 psi is sufficient to inject the material and initiate underchip flow. In accordance with the preferred method of this invention, after the material has penetrated the gap for a distance sufficient to surround the interconnections, the pressure is reduced to a level that restrict further flow into the gap. In general, it is believed that a pressure less than about 150 psi is suitable to prevent gap fill. As a result, material flow into the gap is confined to the perimeter region and surrounds a void underlying the central region, which following curing defines the desired optical window.

Therefore, this invention provides a flip chip microelectronic assembly having an overmolded encapsulant that defines an optical window for transmitting light to and from the active face of the die. Despite the window, the encapsulant extends within the gap sufficient to protect the solder bump interconnections. It is a particular advantage of this invention that the encapsulant material may be formulated to exhibit a coefficient of thermal expansion comparable to the die and substrate. As a result, the encapsulant is effective to reinforce the interconnections to withstand thermally induced stresses due to cyclic heating during use. In commercial materials, adjustment of the coefficient of thermal expansion is accomplished by addition of a filler that renders the encapsulant opaque. Nevertheless, this invention permits use of conventional materials assuring sufficient flow of the encapsulant about the interconnection to provide adequate protection, while forming a widow to assure optical access to the die active face.

While this invention has been described in terms of the preferred embodiments thereof, it is not intended to be so limited, but rather only to the extent set forth in the claims that follow.

## Claims

1. A microelectronic assembly comprising:
a substrate formed of a transparent material,
an integrated circuit die having an active face facing said substrate, said active face including a central region and a perimeter region about the central region,
a plurality of bump interconnections attaching said integrated circuit die to said substrate such that said active face is spaced apart from the substrate by a gap,
a polymeric encapsulant about said integrated circuit die on said substrate and extending within the gap to encapsulate the bump interconnections, and
an optical window defined by said encapsulant within said gap between said central region and said substrate.

2. A microelectronic assembly in accordance with claim 1 wherein said integrated circuit device comprises a rear face opposite said active face, and wherein the polymeric encapsulant is a molded body overlying the rear face.

3. A microelectronic assembly in accordance with claim 1 wherein he central region of said die comprises an optical feature adapted for detecting or emitting optical signals through said substrate.

4. A microelectronic assembly in accordance with claim 1 wherein the polymeric encapsulant is opaque.

5. A microelectronic assembly in accordance with claim 1 wherein the substrate is formed of glass.

6. A microelectronic assembly in accordance with claim 1 wherein the polymeric encapsulant is composed of an epoxy polymer and comprises an inorganic particulate filler.

7. A microelectronic assembly in accordance with claim 1 wherein the substrate is formed of glass and wherein the polymeric encapsulant exhibits a coefficient of thermal expansion between about 6 and 10 ppm per C.

8. A microelectronic assembly in accordance with claim 1 wherein the bump interconnections are bonded to the die at said perimeter region and to said substrate.

9. A microelectronic assembly comprising
a glass substrate,
an integrated circuit die having an active face facing said substrate and a rear face opposite the active face, said active face including a central region and a perimeter region about the central region,
a plurality of solder bump interconnections attaching said integrated circuit die to said substrate, wherein the active face is spaced apart from the substrate by a gap,
an overmolded polymeric encapsulant about said integrated circuit die on said substrate and overlying the rear face of the integrated circuit die, said overmolded polymeric encapsulant extending within the gap to encapsulate the bump interconnections, said encapsulant being formed of a polymeric and an optical window defined by said overmolded polymeric encapsulant within said gap between said central region and said substrate.

10. A method of forming a microelectronic assembly comprising :
attaching a integrated circuit die to a substrate by a plurality of bump interconnections, said integrated circuit die comprising an active face facing said substrate spaced apart by a gap and having a central region and a perimeter region surrounding said central region,
forming a polymeric material about said integrated circuit die on said substrate to form a polymeric encapsulant, said forming being carried out to cause said polymeric material to flow within said gap to encapsulate the bump interconnections and to prevent flow of polymeric material within the gap adjacent the central region to thereby define an optical window between said integrated circuit die and said substrate.

11. A method in accordance with claim 10 wherein said forming comprises molding the polymeric material about the die on the substrate.

12. A method in accordance with claim 10 wherein said integrated circuit die comprises an rear face opposite said active face and wherein said forming step includes molding the polymeric material to overlie said rear face.

13. A method in accordance with claim 10 wherein the central region of said integrated circuit die includes an optical element adapted to detect or receive optical signals through said substrate.

14. A method in accordance with claim 10 wherein the polymeric encapsulant is opaque.

15. A method of forming a microelectronic assembly comprising :
attaching a integrated circuit die to a substrate by a plurality of bump interconnections, said integrated circuit die comprising an active face facing said substrate spaced apart by a gap and having a central region and a perimeter region surrounding said central region,
arranging a mold on said substrate such that the mold and the substrate cooperate to form a molding cavity about the integrated circuit die,
injecting a polymeric material into said molding cavity while applying a pressure at a first value effective to initiate flow of said polymeric material into said gap adjacent said perimeter,
reducing the pressure applied to said polymeric material within said molding cavity to a second value less than the first value and sufficient to restrict flow of said polymeric material within the gap to said perimeter region, thereby preventing the polymeric material from flowing into the gap adjacent the central region, and
curing the polymeric material to form an encapsulant, whereby the encapsulant defines an optical window within the gap adjacent the central region.

16. A method in accordance with claim 15 wherein the first value is greater than about 350 and 750 psi.

17. A method in accordance with claim 15 wherein the second value is less than about 150 psi.

18. A method in accordance with claim 15 wherein is the polymeric material comprises a particulate filler and a curable epoxy polymer compound.

19. A method in accordance with claim 15 wherein the polymeric material comprises an epoxy polymer compound, and wherein the step of curing the polymeric compound comprises heating the epoxy compound within said mold.
